# FASCICULE DE BREVET EUROPEEN

(11) **EP 3 780 123 B1**
(45) Date de publication et mention de la délivrance du brevet: **05.04.2023**
(21) Numéro de dépôt: 20190298.8
(22) Date de dépôt: 10.08.2020
(51) Int. Cl.: H01L 33/00, H01L 25/075, H01L 25/16, H01L 33/40, H01L 27/15, H01L 33/22, H01L 33/32, H01L 33/44

(54) **PROCÉDÉ DE FABRICATION DE DISPOSITIFS ÉLECTRONIQUES**
VERFAHREN ZUR HERSTELLUNG ELEKTRONISCHER VORRICHTUNGEN
METHOD FOR MANUFACTURING ELECTRONIC DEVICES

(30) Priorité: 16.08.2019 FR 1909238
(43) Date de publication de la demande: 17.02.2021
(73) Titulaire: Commissariat à l'Energie Atomique et aux Energies Alternatives, 75015 Paris (FR)
(72) Inventeur: BENAISSA, Lamine, 38054 GRENOBLE CEDEX 9 (FR); RABAROT, Marc, 38054 GRENOBLE CEDEX 9 (FR)
(74) Mandataire: Cabinet Beaumont

(56) Documents cités:
- WO-A1-2008/062783
- WO-A1-2017/068029
- WO-A1-2018/116814
- US-A1- 2019 051 637
- US-A1- 2019 051 792
- US-A1- 2019 229 149

## Description

### Domaine technique

La présente description concerne de façon générale le domaine des dispositifs optoélectroniques. Elle concerne plus particulièrement un procédé de fabrication de dispositifs optoélectroniques comportant chacun une pluralité de diodes semiconductrices, par exemple au nitrure de gallium, et un circuit électronique de contrôle de ces diodes.

### Technique antérieure

On a déjà proposé des dispositifs d'affichage émissifs comportant une matrice de diodes électroluminescentes (LED) au nitrure de gallium (GaN), et un circuit électronique de contrôle permettant de commander individuellement les LED pour afficher des images.

Pour réaliser un tel dispositif, on peut prévoir de fabriquer séparément le circuit de contrôle et la matrice de LED, puis de les hybrider, c'est-à-dire de les empiler en les connectant l'un à l'autre.

Un inconvénient de cette méthode de fabrication réside dans la nécessité d'aligner précisément le circuit de contrôle et la matrice de LED lors de l'étape d'assemblage de ces deux éléments, de façon que chaque LED vienne bien se positionner sur un plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels.

Pour pallier cet inconvénient, il a été proposé, notamment dans les demandes de brevet internationales publiées sous les numéros: WO 2017/194845 A1 (DD16946/B15015) et WO 2019/092357 A1 (DD17951/B16061) précédemment déposées par le demandeur, ainsi que dans la demande de brevet français de numéro d'enregistrement: 18/58201, publiée sous le numéro: FR 3 086 100 A1 (DD18759/B17108), déposée par le demandeur le 13 septembre 2018, de :
réaliser d'abord le circuit de contrôle sous la forme d'un circuit intégré comportant, sur une face, une pluralité de plots métalliques destinés à être connectés aux LED de façon à permettre de contrôler individuellement le courant circulant dans chaque LED ;
reporter ensuite sur la face du circuit de contrôle comportant les plots métalliques un empilement actif de LED s'étendant de façon continue sur toute la surface du circuit de contrôle de façon à connecter une couche semiconductrice de l'empilement aux plots métalliques du circuit de contrôle ; puis
structurer l'empilement actif de LED pour délimiter et isoler les unes des autres les différentes LED du dispositif.

Un avantage de ce procédé de fabrication est que, lors de l'étape de report de l'empilement actif de LED sur le circuit de contrôle, les positions des différentes LED du dispositif dans l'empilement actif ne sont pas encore définies. Il n'y a par conséquent pas de contrainte forte en termes de précision d'alignement lors du report. La délimitation des différentes LED dans l'empilement actif peut ensuite être réalisée par des procédés de structuration d'un substrat et de dépôt de couches isolantes et conductrices sur un substrat, qui offrent une précision d'alignement nettement supérieure à la précision qui peut être obtenue lors d'un report d'un substrat sur un autre.

Il serait toutefois souhaitable d'améliorer au moins en partie certains aspects des procédés décrits dans les demandes de brevet internationales WO 2017/194845 A1 et WO 2019/092357 A1 et dans la demande de brevet français de numéro d'enregistrement: 18/58201, publiée sous le numéro: FR 3 086 100 A1, susmentionnées. Les documents WO 2008/062783 A1, US 2019/0229149 A1, US 2019/0051792 A1, US 2019/0051637 A1, WO 2018/116814 A1 et WO 2017/068029 A1 décrivent d'autres exemples de procédés de fabrication de dispositifs optoélectroniques. Résumé de l'invention

L'objet de la présente invention est tel que récité par la présente revendication 1. D'autres modes avantageux de réalisation de la présente invention sont l'objet des présentes revendications dépendantes. La présente invention fournit un procédé de fabrication de dispositifs électroniques, comportant les étapes successives suivantes :
a) faire croître, sur une face d'un premier substrat, un empilement comportant au moins une couche semiconductrice ;
b) fixer un deuxième substrat sur une face de l'empilement opposée au premier substrat, puis retirer le premier substrat ;
c) fixer un troisième substrat sur une face de l'empilement opposée au deuxième substrat, puis retirer le deuxième substrat ;
d) découper l'ensemble comprenant le troisième substrat et l'empilement en une pluralité de premières puces comportant chacune une portion de l'empilement ; et
e) fixer chaque première puce, par sa face opposée au troisième substrat, sur une face d'un quatrième substrat semiconducteur dans et sur lequel ont été préalablement formés une pluralité de circuits intégrés de contrôle,
procédé dans lequel:
I) à l'étape b), le deuxième substrat est fixé sur la face de l'empilement opposée au premier substrat par collage direct d'une première couche métallique préalablement déposée sur la face de l'empilement opposée au premier substrat avec une deuxième couche métallique préalablement déposée sur le deuxième substrat, ou
II) à l'étape b), le deuxième substrat est fixé sur la face de l'empilement opposée au premier substrat par collage direct d'une première couche diélectrique préalablement déposée sur la face de l'empilement opposée au premier substrat avec une deuxième couche diélectrique préalablement déposée sur le deuxième substrat.

Selon un mode de réalisation, chaque circuit de contrôle comprend une pluralité de plots métalliques de connexion, et, à l'étape e), les premières puces sont disposées respectivement en vis-à-vis des circuits de contrôle, de façon que, dans chaque première puce, ladite au moins une couche semiconductrice de l'empilement soit connectée électriquement aux plots métalliques du circuit de contrôle correspondant.

Selon un mode de réalisation, le procédé comprend en outre, après l'étape e), l'étape suivante :
f) découper l'ensemble comprenant le quatrième substrat semiconducteur et les premières puces en une pluralité de dispositifs électroniques comprenant chacun l'un desdits circuits intégrés de contrôle et la portion correspondante de l'empilement.

Selon un mode de réalisation, le procédé comprend en outre, après l'étape e) et avant l'étape f), une étape de retrait du troisième substrat dans chaque première puce.

Selon un mode de réalisation, le procédé comprend en outre, après l'étape e) et avant l'étape f), une étape de formation, dans chacune desdites portions de l'empilement, de tranchées délimitant une pluralité de composants commandables individuellement.

Selon un mode de réalisation, les première et deuxième couches métalliques sont en titane.

Selon un mode de réalisation, les première et deuxième couches diélectriques sont en oxyde de silicium.

Selon un mode de réalisation, à l'étape c), le troisième substrat est fixé sur la face de l'empilement opposée au deuxième substrat au moyen d'une couche de collage en un matériau polymère.

Selon un mode de réalisation, à l'étape c), le troisième substrat est fixé sur la face de l'empilement opposée au deuxième substrat par collage direct oxyde-oxyde.

Selon un mode de réalisation, le procédé comprend en outre, après l'étape b) et avant l'étape c), une étape d'amincissement de ladite au moins une couche semiconductrice par sa face opposée au deuxième substrat.

Selon un mode de réalisation, le procédé comprend en outre, après l'étape b) et avant l'étape c), une étape de formation de nanostructurations dans ladite au moins une couche semiconductrice, du côté de sa face opposée au deuxième substrat.

Selon un mode de réalisation, le premier substrat est en saphir.

Selon un mode de réalisation, ladite au moins une couche semiconductrice comprend du nitrure de gallium.

Selon un mode de réalisation, l'empilement est un empilement de diode comportant, dans l'ordre à partir de ladite face du premier substrat, des première et deuxième couches semiconductrices de types de conductivité opposés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre de façon schématique une étape d'un procédé de fabrication d'un dispositif optoélectronique selon un mode de réalisation ;
la figure 2 illustre de façon schématique une autre étape d'un procédé de fabrication d'un dispositif optoélectronique selon un mode de réalisation ;
la figure 3 illustre de façon schématique une autre étape d'un procédé de fabrication d'un dispositif optoélectronique selon un mode de réalisation ;
la figure 4 illustre de façon schématique une autre étape d'un procédé de fabrication d'un dispositif optoélectronique selon un mode de réalisation ;
la figure 5 illustre de façon schématique une autre étape d'un procédé de fabrication d'un dispositif optoélectronique selon un mode de réalisation ;
la figure 6 illustre de façon schématique une autre étape d'un procédé de fabrication d'un dispositif optoélectronique selon un mode de réalisation ;
la figure 7 illustre de façon schématique une autre étape d'un procédé de fabrication d'un dispositif optoélectronique selon un mode de réalisation ;
la figure 8 illustre de façon schématique une étape d'une première variante de mise en oeuvre du procédé des figures 1 à 7 ;
la figure 9 illustre de façon schématique une autre étape de la première variante de mise en oeuvre du procédé des figures 1 à 7 ; et
la figure 10 illustre de façon schématique une étape d'une deuxième variante de mise en oeuvre du procédé des figures 1 à 7.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation d'un circuit intégré de contrôle de diodes semiconductrices n'a pas été détaillée, les modes de réalisation décrits étant compatibles avec les structures et procédés de fabrication usuels de tels circuits de contrôle. De plus, la composition et l'agencement des différentes couches d'un empilement actif de diode semiconductrice n'ont pas été détaillés, les modes de réalisation décrits étant compatibles avec les empilements actifs usuels de diodes semiconductrices, notamment au nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

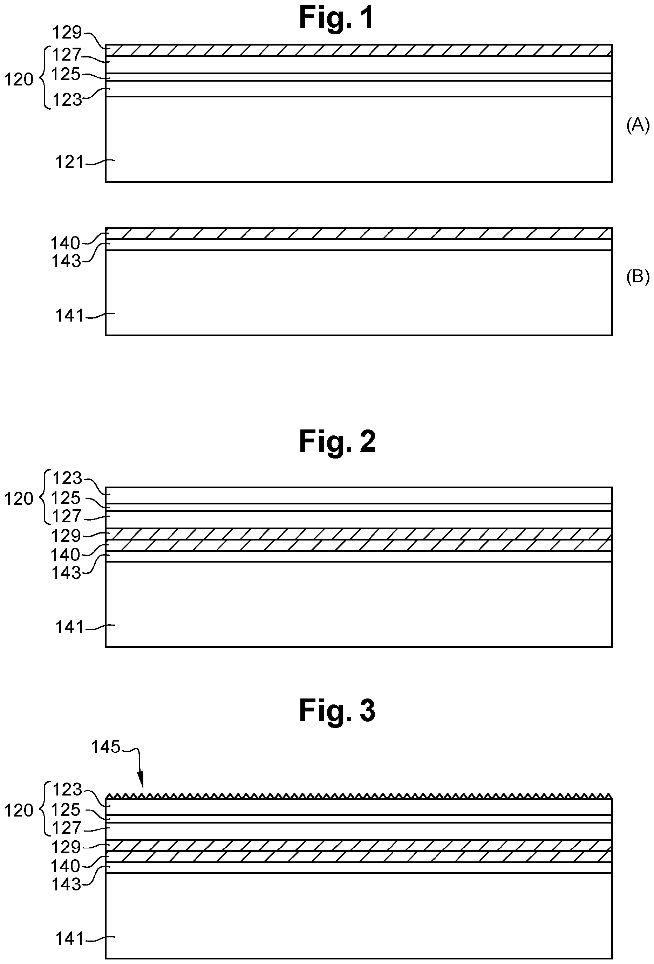

Les figures 1 à 7 sont des vues en coupe illustrant des étapes successives d'un exemple d'un mode de réalisation d'un procédé de fabrication de dispositifs d'affichage comportant chacun une matrice de LED, et un circuit électronique de contrôle permettant de commander individuellement les LED pour afficher des images.

La figure 1 comprend une vue (A) représentant une structure obtenue à l'issue d'étapes de formation d'un empilement actif de LED 120 sur une face, la face supérieure dans l'orientation de la figure 1, d'un substrat de croissance 121. L'empilement actif de LED 120 est par exemple un empilement de LED au nitrure de gallium. L'empilement actif 120 est déposé par épitaxie sur la face supérieure du substrat 121. De préférence, le substrat 121 est un substrat en saphir. Le saphir présente en effet l'avantage de permettre la croissance d'un empilement de LED au nitrure de gallium de très bonne qualité. Dans l'exemple représenté, l'empilement 120 comprend, dans l'ordre à partir de la surface supérieure du substrat 121, une couche de nitrure de gallium dopé de type N 123, une couche émissive 125, et une couche de nitrure de gallium dopé de type P 127. La couche émissive 125 est par exemple constituée par un empilement d'une ou plusieurs couches émissives formant chacune un puits quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 125 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. Dans cet exemple, la face inférieure de la couche émissive 125 est en contact avec la face supérieure de la couche 123, et la face supérieure de la couche émissive 125 est en contact avec la face inférieure de la couche 127. En pratique, un empilement d'une ou plusieurs couches tampon (non représentées - par exemple une couche de nitrure de gallium non dopée "U-GaN") peut faire interface entre le substrat 121 et la couche de nitrure de gallium 123. A titre d'exemple, l'épaisseur de la couche 123 est comprise entre 0,2 et 2 µm, par exemple de l'ordre de 1 µm. A titre d'exemple, l'épaisseur de la couche 125 est comprise entre 30 et 300 nm, par exemple de l'ordre de 100 nm. A titre d'exemple, l'épaisseur de la couche 127 est comprise entre 5 et 300 nm, par exemple de l'ordre de 100 nm. L'empilement 120 s'étend par exemple de façon continue et sur une épaisseur uniforme sur toute la surface supérieure du substrat 121.

La structure de la vue (A) de la figure 1 comprend en outre, sur la face supérieure de l'empilement actif de diode 120, une couche métallique 129. Dans l'exemple représenté, la couche métallique 129 est déposée sur et en contact avec la face supérieure de la couche de nitrure de gallium 127. La couche métallique 129 revêt par exemple sensiblement toute la surface supérieure de l'empilement actif 120. La couche métallique 129 est par exemple déposée par une méthode de dépôt sous vide, par exemple par dépôt physique en phase vapeur (PVD), par pulvérisation sous vide, ou par dépôt chimique en phase vapeur (CVD), ou par dépôt par évaporation sous vide (EVAP) . La couche métallique 129 a notamment une fonction de reprise de contact électrique sur la couche semiconductrice 127 de l'empilement de LED. La couche métallique 129 peut en outre avoir une fonction de réflecteur optique (miroir), une fonction de barrière à la diffusion d'éléments métalliques, et/ou une fonction d'élément de fixation de l'empilement actif 120 à un autre substrat par collage direct métal-métal.

A titre d'exemple, la couche métallique 129 est constituée d'un empilement de plusieurs couches métalliques distinctes (non détaillées sur les figures) comprenant, dans l'ordre à partir de la face supérieure de la couche semiconductrice 127 :
- une première couche métallique, par exemple en nickel, en indium, en titane, ou en un oxyde indium-étain (ITO), en contact avec la face supérieure de la couche semiconductrice 127 et assurant la reprise d'un contact électrique sur la couche semiconductrice 127 ;
- une deuxième couche métallique, par exemple en aluminium, en argent ou en platine, en contact avec la face supérieure de la première couche métallique, ayant une fonction de réflecteur optique ;
- une troisième couche métallique, par exemple en nitrure de titane ou en nitrure de tantale, en contact avec la face supérieure de la deuxième couche métallique, formant une barrière à la diffusion d'éléments métalliques ; et
- une quatrième couche métallique, par exemple en titane, en contact avec la face supérieure de la troisième couche métallique, destinée à assurer la fixation ultérieure de l'empilement 120 sur un substrat de report par collage direct métal-métal.

A titre d'exemple, les première, deuxième, troisième et quatrième couches métalliques de la couche 129 ont respectivement des épaisseurs de l'ordre de 5 nm, 100 nm, 25 nm et 500 nm.

La figure 1 comprend en outre une vue (B) illustrant une structure obtenue à l'issue d'une étape de formation d'une couche métallique de collage 140 sur une face, la face supérieure dans l'orientation de la figure 1, d'un premier substrat de report temporaire 141. Le substrat 141 est par exemple en silicium. La couche métallique de collage 140 est de préférence en le même matériau que la partie supérieure de la couche métallique 129, par exemple en titane. La couche métallique 140 est par exemple déposée par une méthode de dépôt sous vide, par exemple par PVD, par pulvérisation sous vide, ou par CVD. L'épaisseur de la couche métallique de collage 140 est par exemple de l'ordre de 10 nm. La couche 140 s'étend par exemple de façon continue sur toute la surface supérieure du substrat 141.

Dans l'exemple représenté, préalablement au dépôt de la couche métallique de collage 140, une couche d'arrêt de gravure 143 est déposée sur la face supérieure du substrat de report temporaire 141. La couche 143 est par exemple en nitrure d'aluminium (AlN). La couche 143 s'étend de préférence de façon continue sur toute la surface supérieure du substrat 141. L'épaisseur de la couche 143 est par exemple de l'ordre de 10 nm. A titre d'exemple, la couche 143 est en contact, par sa face inférieure, avec la face supérieure du substrat 141, et, par sa face supérieure, avec la couche métallique de collage 140.

La figure 2 illustre la structure obtenue à l'issue d'une étape de report et de fixation de l'empilement actif de LED 120 sur la face supérieure du substrat de report temporaire 141. Pour cela, l'ensemble comportant le substrat de croissance 121, l'empilement actif de LED 120 et la couche métallique 129 peut être retourné et rapporté sur le substrat temporaire 141 de façon à mettre la face supérieure (dans l'orientation de la vue (A) de la figure 1) de la couche métallique 129 en contact avec la face supérieure de la couche métallique 140. Dans cet exemple, la fixation de l'empilement actif 120 sur le substrat de report temporaire 141 est obtenue par collage direct de la face inférieure (dans l'orientation de la figure 2) de la couche métallique 129 sur la face supérieure de la couche métallique 140. Par collage direct, on entend ici un collage sans apport de matière intermédiaire entre les deux surfaces assemblées, par exemple un collage moléculaire, un collage par thermocompression, ou encore un collage eutectique. A titre d'exemple, le collage est réalisé à température ambiante et suivi d'un recuit à une température de l'ordre de 200°C. Préalablement au collage, une étape de préparation des surfaces externes des couches métalliques 129 et 140 à assembler peut être prévue, par exemple par polissage mécano-chimique, de façon à obtenir une rugosité de surface des couches métalliques 129 et 140 à assembler relativement faible, par exemple inférieure à 0,5 nm RMS.

Une fois l'empilement actif de LED 120 fixé sur la face supérieure du substrat de report temporaire 141, le substrat de croissance 121 est retiré de façon à exposer la face supérieure (dans l'orientation de la figure 2) de la couche semiconductrice 123. Le substrat 121 est par exemple détaché de l'empilement actif 120 au moyen d'un faisceau laser projeté à travers le substrat 121 depuis sa face opposée à l'empilement actif 120 (procédé de type laser lift-off). Une étape de nettoyage chimique de la face supérieure de la couche semiconductrice 123 (ou de la couche tampon de nitrure de gallium non dopée), par exemple au moyen d'une solution à base de chlorure d'hydrogène, peut être mise en oeuvre après le retrait du substrat 121.

La figure 3 illustre la structure obtenue à l'issue d'une étape ultérieure d'amincissement puis de nano-structuration de la couche semiconductrice 123 (et/ou de la couche tampon de nitrure de gallium non dopée), à partir de sa face opposée au substrat temporaire 141, à savoir sa face supérieure dans l'orientation de la figure 3.

Dans un premier temps, la couche 123 peut être amincie à partir de sa face supérieure, par exemple par gravure plasma, par exemple par gravure de type ICP (de l'anglais "Inductively Coupled Plasma" - plasma couplé inductivement), ou par gravure ionique par faisceau d'ions IBE (Ion Beam Etching). Lors de cette étape, la couche 123 (et/ou la couche tampon de nitrure de gallium non dopée) est amincie de manière uniforme sur sensiblement toute sa surface.

Dans un second temps, une étape de structuration de la face supérieure de la couche 123 peut être mise en oeuvre. Lors de cette étape, des nano-structurations 145 sont formées dans la couche 123, par exemple par lithographie. La formation des nano-structurations 145 comprend par exemple une étape de formation d'un masque de résine (non visible sur la figure 3) sur la face supérieure de la couche 123, suivie d'une étape de gravure d'une partie de l'épaisseur de la couche 123 au travers d'ouvertures du masque. Les ouvertures du masque, de dimensions nanométriques, sont par exemple formées par gravure par faisceau d'électrons, ou par un procédé de nano-impression. La gravure de la couche 123 au travers des ouvertures du masque pour former les nano-structurations 145 est par exemple une gravure plasma.

Les nano-structurations 145 permettent avantageusement d'améliorer l'extraction de la lumière émise par les LED dans le dispositif final. A titre d'exemple, les structurations ont, en vue de dessus, une forme carrée, triangulaire, circulaire, ou hexagonale. Les nano-structurations présentent par exemple une largeur comprise entre 100 et 800 nm et une hauteur comprise entre 100 et 400 nm.

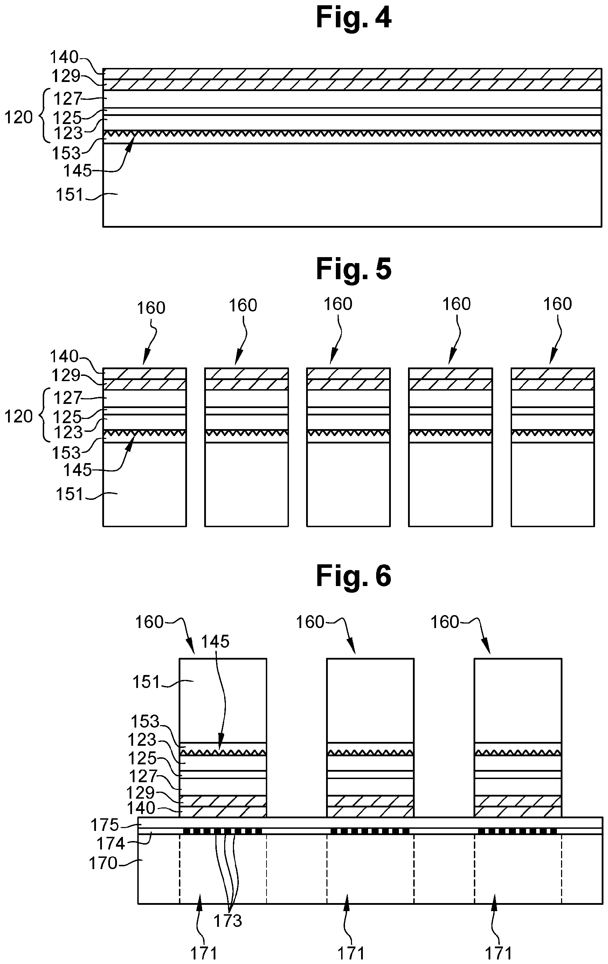

La figure 4 illustre la structure obtenue à l'issue d'une étape ultérieure de report et de fixation de l'empilement actif de LED 120 sur la face supérieure d'un deuxième substrat de report temporaire 151. Lors de cette étape, l'ensemble comportant le premier substrat temporaire 141, les couches 129, 140 et 143, et l'empilement actif de LED 120, peut être retourné (par rapport à l'orientation de la figure 3) de façon à fixer la face de l'empilement de LED 120 opposée au substrat 141 à la face supérieure du substrat 151. La face de la couche semiconductrice 123 opposée au substrat 141, à savoir sa face inférieure dans l'orientation de la figure 4, peut être fixée à la face supérieure du substrat 151 au moyen d'une couche de collage 153 en un matériau polymère. A titre d'exemple, le collage est réalisé à une température de l'ordre de 200°C avec application d'une pression entre les deux éléments assemblés.

Une fois l'empilement actif de LED 120 fixé sur la face supérieure du substrat, le premier substrat de report temporaire 141 et la couche d'arrêt de gravure 143 sont retirés de façon à exposer la face supérieure de la couche métallique 140. Le substrat 141 est par exemple retiré par meulage, puis gravure chimique ou sèche. La couche d'arrêt 143 peut être retirée par gravure chimique ou sèche. Une étape de nettoyage de la surface supérieure de la couche métallique 140, par exemple par polissage mécano-chimique et/ou nettoyage chimique, peut être mise en oeuvre après le retrait du substrat 141 et de la couche d'arrêt 143.

La figure 5 illustre une étape ultérieure de découpe de l'ensemble comprenant le substrat 151, la couche de collage 153, l'empilement actif de LED 120 et les couches métalliques 129 et 140, en une pluralité de puces élémentaires 160, par exemple de mêmes dimensions. La découpe des puces élémentaires 160 est par exemple effectuée par sciage. Chaque puce 160 comprend une portion de l'empilement actif de LED 120 de dimensions sensiblement égales aux dimensions de la matrice de LED de l'un des dispositifs d'affichage que l'on cherche à réaliser. A ce stade, dans chaque puce 160, chacune des couches 123, 125 et 127 de l'empilement 120 et chacune des couches métalliques 129 et 140 s'étend de façon continue sur sensiblement toute la surface de la puce. Autrement dit, à ce stade, les LED élémentaires du dispositif d'affichage ne sont pas encore individualisées.

La figure 6 illustre une étape ultérieure de report des puces élémentaires 160 sur un substrat semiconducteur 170, par exemple en silicium, dans et sur lequel ont été préalablement formés une pluralité de circuits intégrés de contrôle 171. Les circuits de contrôle 171 sont par exemple réalisés en technologie CMOS. Chaque circuit de contrôle 171 correspond au circuit de contrôle de l'un des dispositifs d'affichage que l'on cherche à réaliser. A titre d'exemple, chaque circuit de contrôle 171 comprend, du côté de sa face supérieure, pour chacune des LED du dispositif d'affichage, des plots métalliques de connexion 173 destinés à être connectés à l'une des électrodes des LED, de façon à pouvoir commander un courant circulant au sein des LED et/ou appliquer une tension aux bornes des LED. Le circuit de contrôle comprend par exemple, pour chaque LED, connectée aux plots métalliques 173 dédiés aux LED, une cellule élémentaire de contrôle (non détaillée) comportant un ou plusieurs transistors, permettant de contrôler individuellement le courant circulant dans la LED et/ou une tension appliquée aux bornes de la LED. Les plots métalliques 173 peuvent être latéralement entourés par un matériau isolant 174, par exemple de l'oxyde de silicium, de façon que le circuit de contrôle 171 présente une surface supérieure sensiblement plane comprenant une alternance (ou damier) de régions métalliques 173 et de régions isolantes 174.

Dans cet exemple, préalablement au report des puces 160 sur le substrat 170, une couche métallique de collage 175 est déposée sur la face supérieure du substrat 170. La couche métallique 175 s'étend de façon continue sur sensiblement toute la surface supérieure du substrat 170. La couche métallique 175 revêt notamment sensiblement toute la surface supérieure de chacun des circuits de contrôle 171. En particulier, la couche métallique 175 est en contact avec les plots métalliques de connexion 173 de chaque circuit de contrôle 171.

La couche métallique 175 est par exemple en le même matériau que la couche métallique 140, par exemple en titane. L'épaisseur de la couche métallique 175 est par exemple de l'ordre de 200 nm.

Après le dépôt de la couche 175, une étape de préparation de la surface supérieure de la couche 175 peut être prévue, par exemple par polissage mécano-chimique, de façon à obtenir une rugosité de surface de la couche 175 relativement faible, par exemple inférieure à 0,5 nm RMS.

Les puces 160 sont ensuite reportées et fixées sur le substrat 170 par collage direct de la face de la couche métallique 140 opposée au substrat 151, à savoir sa face inférieure dans l'orientation de la figure 6, sur la face supérieure de la couche métallique 175. Chaque puce 160 est disposée en vis-à-vis de l'un des circuits de contrôle 171. Lors de cette étape, les positions des différentes LED de chaque dispositif d'affichage dans l'empilement actif 120 ne sont pas encore définies. Il n'y a par conséquent pas de contrainte forte en termes de précision d'alignement lors du report des puces 160 sur le substrat 170. Les puces 160 peuvent être reportées une à une sur le substrat 170, ou de façon collective.

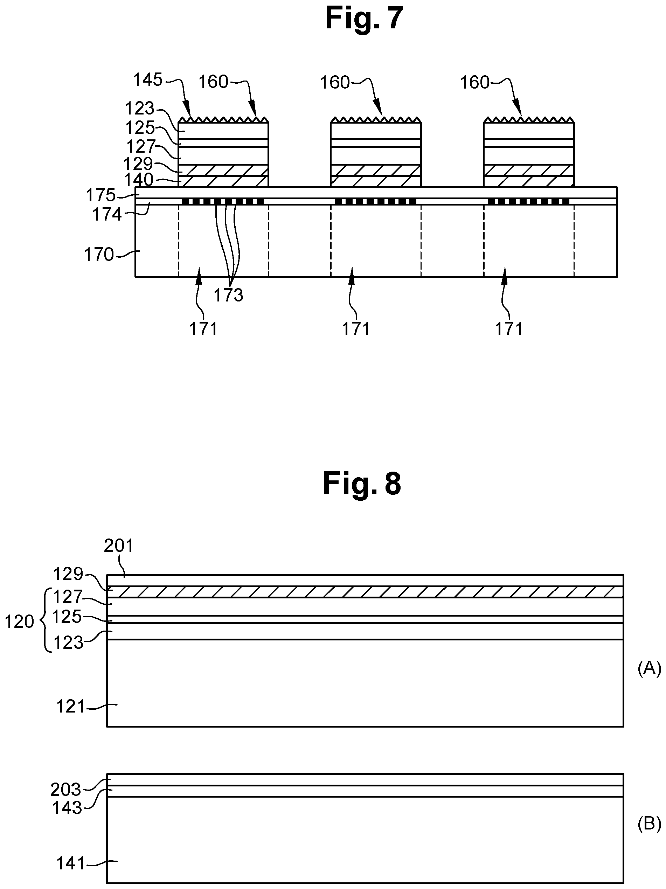

La figure 7 illustre la structure obtenue à l'issue d'une étape ultérieure de retrait du substrat temporaire 151 des puces 160. Le retrait du substrat 151 peut être réalisé par dissolution de la couche de colle polymère 153, par exemple au moyen d'une solution chimique ou par irradiation par un rayonnement ultraviolet (dans le cas d'un substrat 151 en verre).

Une étape supplémentaire (non détaillée sur la figure 7) de dépôt d'une couche diélectrique de passivation sur la surface supérieure de la structure peut en outre être prévue. A titre d'exemple, une couche d'un matériau diélectrique de passivation, par exemple de l'oxyde de silicium, est déposée sur toute la surface de la structure de la figure 7, sur une épaisseur supérieure à l'épaisseur cumulée des couches métalliques 140 et 129 et de l'empilement actif 120, puis cette couche est planarisée, par exemple par polissage mécanochimique, de façon à obtenir un assemblage présentant une surface supérieure sensiblement plane. A titre d'exemple, à l'issue de l'étape de planarisation, la face supérieure de la couche semiconductrice 123 affleure au niveau de la face supérieure de la couche diélectrique de passivation (non représentée).

A l'issue des étapes de la figure 7, on obtient un substrat 170 dans et sur lequel sont intégrés une pluralité de circuits de contrôle 171, chaque circuit de contrôle élémentaire étant revêtu par une portion de l'empilement actif de LED 120 s'étendant de façon continue sur sensiblement toute la surface du circuit de contrôle 171, la couche semiconductrice 123 de l'empilement actif de LED 120 étant connecté électriquement aux plots métalliques 173 du circuit de contrôle.

Des étapes ultérieures de délimitation et d'individualisation d'une pluralité de LED élémentaires dans chaque portion de l'empilement actif 120 sont ensuite mises en oeuvre, par des procédés usuels de structuration de couches semiconductrices et de dépôt de couches isolantes et conductrices sur un substrat. Ce procédé ne sera pas détaillé ci-après, les modes de réalisation décrits étant compatibles avec des procédés connus de délimitation et d'individualisation de LED élémentaires dans un empilement actif de LED préalablement reporté sur un circuit intégré de contrôle, par exemple des procédés du type décrit dans l'une des ou les demandes de brevet internationales WO 2017/194845 A1 et WO 2019/092357 A1 susmentionnées, et/ou dans la demande de brevet français de numéro d'enregistrement: 18/58201, publiée sous le numéro: FR 3 086 100 A1, susmentionnée. Ces procédés comprennent notamment la formation, dans chaque portion de l'empilement actif 120, de tranchées délimitant une pluralité de LED connectées respectivement à des plots métalliques 173 distincts du circuit de contrôle 171 sous-jacent.

A l'issue du procédé de délimitation et d'individualisation des LED élémentaires, on obtient une structure comportant une pluralité de dispositifs d'affichage comportant chacun un circuit de contrôle 171 intégré dans et sur le substrat 170, et une matrice de LED élémentaires commandables individuellement disposée sur et en contact avec le circuit de contrôle 171. Cette structure peut ensuite être découpée en puces individuelles comportant chacune un unique dispositif d'affichage.

Un avantage du procédé décrit en relation avec les figures 1 à 7 est qu'il ne comprend pas d'étape de découpe du substrat de croissance 121 en puces individuelles. Ceci est particulièrement avantageux dans le cas d'un substrat de croissance en saphir, qui est un matériau particulièrement difficile à découper.

Un autre avantage du procédé décrit en relation avec les figures 1 à 7 est que l'étape de démontage du substrat de croissance 121 est réalisée avant le report de l'empilement actif de LED 120 sur le substrat semiconducteur 170 dans et sur lequel sont intégrés les circuits de contrôle 171. Ceci permet, dans le cas où ce démontage est réalisé par projection d'un faisceau laser au travers du substrat 121 (procédé de type laser lift-off), de ne pas risquer d'endommager les circuits de contrôle 171.

Un autre avantage est lié à la possibilité d'amincir et/ou de structurer la couche semiconductrice 123 par sa face opposée à la couche semiconductrice 127, après le retrait du substrat de croissance 121, et avant le report de l'empilement actif de LED 120 sur le deuxième substrat de report temporaire 151 (étapes de la figure 3). L'étape d'amincissement permet notamment de rattraper d'éventuels défauts d'homogénéité d'épaisseur de la couche 123.

On notera par ailleurs que, lors de l'étape de report des puces 160 sur le substrat 170, on peut prévoir de sélectionner les puces reportées sur la base d'une cartographie des défauts, notamment des défauts d'homogénéité d'épaisseur, réalisée lors d'une étape préalable au report, par exemple avant la découpe du substrat 151 en puces individuelles. Ceci permet notamment d'éliminer les puces 160 présentant des défauts critiques.

Un autre avantage du procédé décrit en relation avec les figures 1 à 7 est que, du fait de la découpe de l'empilement actif de LED 120 en puces individuelles avant report sur le substrat semiconducteur 170, les pertes de matière liées aux éventuelles différences de format entre le substrat semiconducteur 170 (par exemple un substrat de l'ordre de 200 ou 300 mm de diamètre) et le substrat de croissance 121 de l'empilement de LED (par exemple un substrat de l'ordre de 100 mm de diamètre), sont minimisées. Par ailleurs, des puces sélectionnées d'après une cartographie d'épaisseurs peuvent provenir de substrats de croissance différents et être regroupées sur un substrat semiconducteur 170 grand format (de l'ordre de 200 ou 300 mm) en étant homogènes en épaisseur, bien que provenant de sources d'épitaxie différentes. Cette homogénéité en épaisseur permet de viser, dans la suite du processus de fabrication, des résolutions d'écran et des densités de pixels plus importantes.

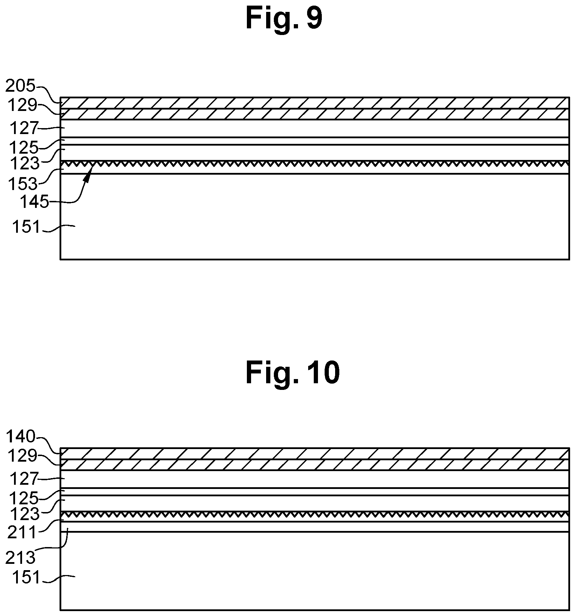

Les figures 8 et 9 illustrent une variante de mise en oeuvre du procédé décrit en relation avec les figures 1 à 7.

La figure 8 comprend une vue (A) similaire à la vue (A) de la figure 1, représentant une structure obtenue à l'issue d'étapes de formation d'un empilement actif de LED 120 sur la face supérieure d'un substrat de croissance 121. La figure 8 comprend en outre une vue (B) similaire à la vue (B) de la figure 1, illustrant une structure obtenue à l'issue d'une étape de préparation d'un premier substrat de report temporaire 141 destiné à être fixé à la face de l'empilement actif de LED 120 opposée au substrat de croissance 121.

La variante de la figure 8 diffère de ce qui a été décrit précédemment en relation avec la figure 1 en ce que, dans la variante de la figure 8, la couche métallique 129 est revêtue d'une couche diélectrique 201, par exemple en oxyde de silicium, s'étendant de façon continue sur sensiblement toute la surface du substrat 121. La couche diélectrique 201 est par exemple en contact avec la face supérieure de la couche métallique 129.

Dans cet exemple, la couche métallique 129 est par exemple constituée d'un empilement de plusieurs couches métalliques distinctes (non détaillées sur la figure 8) comprenant, dans l'ordre à partir de la face supérieure de la couche semiconductrice 127 :
- une première couche métallique, par exemple en nickel, en indium, en titane, ou en un oxyde indium-étain (ITO), en contact avec la face supérieure de la couche semiconductrice 127 et assurant la reprise d'un contact électrique sur la couche semiconductrice 127 ; et
- une deuxième couche métallique, par exemple en aluminium, en argent ou en platine, en contact avec la face supérieure de la première couche métallique, ayant une fonction de réflecteur optique.

La variante de la figure 8 diffère en outre de ce qui a été décrit précédemment en relation avec la figure 1 en ce que, dans la variante de la figure 8, la couche métallique 140 revêtant le substrat temporaire 141 est omise, et remplacée par une couche diélectrique 203, par exemple en le même matériau que la couche 201, par exemple de l'oxyde de silicium ou du nitrure de silicium. La couche diélectrique 203 s'étend de façon continue sur sensiblement toute la surface du substrat temporaire 141. La couche diélectrique 203 est par exemple en contact avec la face supérieure de la couche d'arrêt 143.

Dans la variante des figures 8 et 9, la fixation de l'empilement actif de LED 120 est obtenue par collage direct de la face de la couche diélectrique 201 opposée au substrat 121 sur la face de la couche diélectrique 203 opposée au substrat 141. Autrement dit, le collage direct métal-métal décrit en relation avec la figure 2 est remplacé par un collage direct diélectrique-diélectrique.

Les étapes suivantes du procédé sont identiques ou similaires à ce qui a été décrit précédemment, jusqu'au retrait du premier substrat de report temporaire 141 (figure 4) .

La figure 9 illustre la structure obtenue après le retrait du premier substrat de report temporaire 141. Dans cet exemple, après avoir retiré le substrat de report temporaire 141, la couche d'arrêt de gravure 143 et les couches diélectriques de collage 201 et 203 sont également retirées de façon à exposer la face supérieure de la couche métallique 129. Une couche métallique de collage 205 s'étendant de façon continue sur toute la surface de l'empilement actif de LED 120 peut ensuite être déposée sur et en contact avec la face supérieure de la couche 129. La couche 205 est destinée à permettre la mise en oeuvre d'une étape ultérieure de collage direct métal-métal des puces individuelles 160 sur la face supérieure du substrat semiconducteur 170 (figure 6). La couche 205 est par exemple en le même matériau que la couche 175 de la figure 6, par exemple du titane. Une étape de préparation de la face de la couche 205 opposée à la couche 129 peut être prévue, par exemple par polissage mécano-chimique, de façon à obtenir une rugosité de surface de la couche 205 relativement faible, par exemple inférieure à 0,5 nm RMS.

Les étapes suivantes du procédé sont par exemple identiques ou similaires à ce qui a été décrit en relation avec les figures 5 à 7.

La figure 10 illustre une autre variante de mise en oeuvre du procédé décrit en relation avec les figures 1 à 7.

La variante de la figure 10 diffère de l'exemple des figures 1 à 7 principalement en ce que, dans la variante de la figure 10, le collage de l'empilement actif de LED 120 sur le deuxième substrat de report 151 est réalisé non pas au moyen d'une colle polymère 153 (figure 4), mais par collage direct diélectrique-diélectrique. Pour cela, avant le report de l'empilement actif de LED 120 sur le substrat 151, une couche diélectrique 211, par exemple en oxyde de silicium, est déposée sur la face de la couche 123 opposée au premier substrat de report temporaire 141, et une couche diélectrique 213, par exemple en le même matériau que la couche 211, est déposée sur la face supérieure du substrat 151. La couche 211 s'étend de façon continue sur sensiblement toute la surface de l'empilement de LED 120, et la couche 213 s'étend de façon continue sur sensiblement toute la surface du substrat de support 151. L'empilement actif de LED est ensuite fixé au substrat 151 par collage direct de la face de la couche diélectrique 211 opposée au substrat 141 sur la face de la couche diélectrique 213 opposée au substrat 151.

La figure 10 représente une vue similaire à la vue de la figure 4, à l'issue de l'étape de retrait du premier substrat de report temporaire 141.

Les étapes suivantes du procédé sont par exemple identiques ou similaires à ce qui a été décrit en relation avec les figures 5 à 7.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, la variante des figures 8 et 9 et la variante de la figure 10 peuvent être combinées.

Par ailleurs, les étapes de la figure 3 d'amincissement et/ou de nano-structuration de la couche 123 peuvent être omises. A titre d'exemple, seule l'étape de nano-structuration de la couche 123 est mise en oeuvre, l'étape préalable d'amincissement de la couche 123 étant omise. Dans une autre variante, seule l'étape d'amincissement de la couche 123 est mise en oeuvre, l'étape de nano-structuration de la couche 123 étant omise. Dans une autre variante, l'étape d'amincissement de la couche 123 et l'étape de nano-structuration de la couche 123 sont toutes les deux omises.

En outre, les types de conductivité des couches semiconductrices 123 (de type N dans les exemples décrits) et 127 (de type P dans les exemples décrits) peuvent être inversés.

Par ailleurs, bien que l'on ait décrit uniquement des exemples de réalisation de dispositifs d'affichage à base de LED au nitrure de gallium, les modes de réalisation décrits peuvent être adaptés à la fabrication d'un capteur comportant une pluralité de photodiodes au nitrure de gallium adressables individuellement pour acquérir une image.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semiconducteurs III-V.
Les modes de réalisation décrits peuvent en outre être adaptés à la fabrication de tout dispositif électronique comportant une pluralité de composants semiconducteurs au nitrure de gallium ou à base d'autres matériaux semiconducteurs, par exemple des matériaux III-V, et un circuit intégré adapté à commander individuellement ces composants. A titre d'exemple, les composants semiconducteurs peuvent être des composants de puissance, par exemple des transistors, diodes, etc.

Enfin, la mise en oeuvre pratique des modes de réalisation et variantes décrits est à la portée de l'homme du métier à partir des indications fonctionnelles données ci-dessus. Les revendications qui suivent définissent l'objet de la présente invention.

## Revendications

1. Procédé de fabrication de dispositifs électroniques, comportant les étapes successives suivantes :
a) faire croître, sur une face d'un premier substrat (121), un empilement (120) comportant au moins une couche semiconductrice (123, 125, 127) ;
b) fixer un deuxième substrat (141) sur une face de l'empilement (120) opposée au premier substrat (121), puis retirer le premier substrat (121) ;
c) fixer un troisième substrat (151) sur une face de l'empilement (120) opposée au deuxième substrat (141), puis retirer le deuxième substrat (141) ;
d) découper l'ensemble comprenant le troisième substrat (151) et l'empilement (120) en une pluralité de premières puces (160) comportant chacune une portion de l'empilement (120) ; et
e) fixer chaque première puce (160), par sa face opposée au troisième substrat (151), sur une face d'un quatrième substrat semiconducteur (170) dans et sur lequel ont été préalablement formés une pluralité de circuits intégrés de contrôle (171),
dans lequel :
I) à l'étape b), le deuxième substrat (141) est fixé sur la face de l'empilement (120) opposée au premier substrat (121) par collage direct d'une première couche métallique (129) préalablement déposée sur la face de l'empilement (120) opposée au premier substrat (121) avec une deuxième couche métallique (140) préalablement déposée sur le deuxième substrat (141), ou
II) à l'étape b), le deuxième substrat (141) est fixé sur la face de l'empilement (120) opposée au premier substrat (121) par collage direct d'une première couche diélectrique (201) préalablement déposée sur la face de l'empilement (120) opposée au premier substrat (121) avec une deuxième couche diélectrique (203) préalablement déposée sur le deuxième substrat (141).

2. Procédé selon la revendication 1, dans lequel chaque circuit de contrôle (171) comprend une pluralité de plots métalliques de connexion (173), et dans lequel, à l'étape e), les premières puces sont disposées respectivement en vis-à-vis des circuits de contrôle (171), de façon que, dans chaque première puce, ladite au moins une couche semiconductrice (123, 125, 127) de l'empilement soit connectée électriquement aux plots métalliques (173) du circuit de contrôle (171) correspondant.

3. Procédé selon la revendication 2, comprenant en outre, après l'étape e), l'étape suivante :
f) découper l'ensemble comprenant le quatrième substrat semiconducteur (170) et les premières puces en une pluralité de dispositifs électroniques comprenant chacun l'un desdits circuits intégrés de contrôle (171) et la portion correspondante de l'empilement (120).

4. Procédé selon la revendication 3, comprenant en outre, après l'étape e) et avant l'étape f), une étape de retrait du troisième substrat (151) dans chaque première puce (160).

5. Procédé selon la revendication 3 ou 4, comprenant en outre, après l'étape e) et avant l'étape f), une étape de formation, dans chacune desdites portions de l'empilement (120), de tranchées délimitant une pluralité de composants commandables individuellement.

6. Procédé selon l'alternative I) de la revendication 1, dans lequel les première (129) et deuxième (140) couches métalliques sont en titane.

7. Procédé selon l'alternative II) de la revendication 1, dans lequel les première (201) et deuxième (203) couches diélectriques sont en oxyde de silicium.

8. Procédé selon l'une quelconque des revendications 1 à 7, dans lequel, à l'étape c), le troisième substrat (151) est fixé sur la face de l'empilement (120) opposée au deuxième substrat (141) au moyen d'une couche de collage (153) en un matériau polymère.

9. Procédé selon l'une quelconque des revendications 1 à 7, dans lequel, à l'étape c), le troisième substrat (151) est fixé sur la face de l'empilement (120) opposée au deuxième substrat (141) par collage direct oxyde-oxyde.

10. Procédé selon l'une quelconque des revendications 1 à 9, comprenant en outre, après l'étape b) et avant l'étape c), une étape d'amincissement de ladite au moins une couche semiconductrice (123, 125, 127) par sa face opposée au deuxième substrat (141).

11. Procédé selon l'une quelconque des revendications 1 à 10, comprenant en outre, après l'étape b) et avant l'étape c), une étape de formation de nanostructurations (145) dans ladite au moins une couche semiconductrice (123, 125, 127), du côté de sa face opposée au deuxième substrat (141).

12. Procédé selon l'une quelconque des revendications 1 à 11, dans lequel le premier substrat (121) est en saphir.

13. Procédé selon l'une quelconque des revendications 1 à 12, dans lequel ladite au moins une couche semiconductrice (123, 125, 127) comprend du nitrure de gallium.

14. Procédé selon l'une quelconque des revendications 1 à 13, dans lequel l'empilement est un empilement de diode (120) comportant, dans l'ordre à partir de ladite face du premier substrat (121), des première (123) et deuxième (127) couches semiconductrices de types de conductivité opposés.

## Patentansprüche

1. Verfahren zur Herstellung elektronischer Vorrichtungen, das die folgenden aufeinanderfolgenden Schritte aufweist:
a) Wachsen auf einer Oberfläche eines ersten Substrats (121) eines Stapels (120), der mindestens eine Halbleiterschicht (123, 125, 127) aufweist;
b) Bonden eines zweiten Substrats (141) an eine Oberfläche des Stapels (120) gegenüber dem ersten Substrat (121) und anschließendes Entfernen des ersten Substrats (121);
c) Bonden eines dritten Substrats (151) an eine Oberfläche des Stapels (120) gegenüber dem zweiten Substrat (141) und anschließendes Entfernen des zweiten Substrats (141);
d) Schneiden der Anordnung , die das dritte Substrat (151) und den Stapel (120) aufweist, in eine Vielzahl von ersten Chips (160), die jeweils einen Teil des Stapels (120) aufweisen; und
e) Bonden jedes ersten Chips (160) mit seiner dem dritten Substrat (151) gegenüberliegenden Oberfläche an eine Oberfläche eines vierten Halbleitersubstrats (170), in und auf dem zuvor eine Vielzahl von integrierten Steuerschaltungen (171) ausgebildet wurde,
wobei:
I) im Schritt b) das zweite Substrat (141) mit der dem ersten Substrat (121) gegenüberliegenden Oberfläche des Stapels (120) durch direktes Bonden einer ersten Metallschicht (129), die zuvor auf der dem ersten Substrat (121) gegenüberliegenden Oberfläche des Stapels (120) abgeschieden wurde, mit einer zweiten Metallschicht (140), die zuvor auf dem zweiten Substrat (141) abgeschieden wurde, verbunden wird, oder
II) im Schritt b) das zweite Substrat (141) mit der dem ersten Substrat (121) gegenüberliegenden Oberfläche des Stapels (120) durch direktes Bonden einer ersten dielektrischen Schicht (201), die zuvor auf der dem ersten Substrat (121) gegenüberliegenden Oberfläche des Stapels (120) abgeschieden wurde, mit einer zweiten dielektrischen Schicht (203), die zuvor auf dem zweiten Substrat (141) abgeschieden wurde, verbunden wird.

2. Verfahren nach Anspruch 1, wobei jede Steuerschaltung (171) eine Vielzahl von Metallanschlussflächen (173) aufweist und wobei im Schritt e) die ersten Chips jeweils gegenüber den Steuerschaltungen (171) angeordnet sind, so dass in jedem ersten Chip die mindestens eine Halbleiterschicht (123, 125, 127) des Stapels elektrisch mit den Metallanschlussflächen (173) der entsprechenden Steuerschaltung (171) verbunden ist.

3. Verfahren nach Anspruch 2, das ferner nach Schritt e) den folgenden Schritt aufweist::
f) Schneiden der Anordnung, die das vierte Halbleitersubstrat (170) und die ersten Chips aufweist, in eine Vielzahl von elektronischen Vorrichtungen, die jeweils eine der integrierten Steuerschaltungen (171) und den entsprechenden Teil des Stapels (120) aufweisen.

4. Verfahren nach Anspruch 3, das ferner nach Schritt e) und vor Schritt f) einen Schritt des Entfernens des dritten Substrats (151) von jedem ersten Chip (160) aufweist.

5. Verfahren nach Anspruch 3 oder 4, das ferner nach Schritt e) und vor Schritt f) einen Schritt des Ausbildens von Gräben in jedem der Abschnitte des Stapels (120) aufweist, die eine Vielzahl von individuell steuerbaren Komponenten begrenzen.

6. Verfahren nach der Alternative I) des Anspruchs 1, wobei die erste (129) und die zweite (140) Metallschicht aus Titan hergestellt sind.

7. Verfahren nach der Alternative II) des Anspruchs 1, wobei die erste (201) und die zweite (203) dielektrische Schicht aus Siliziumoxid hergestellt sind.

8. Verfahren nach einem der Ansprüche 1 bis 7, wobei im Schritt c) das dritte Substrat (151) mit der dem zweiten Substrat (141) gegenüberliegenden Oberfläche des Stapels (120) mittels einer Verbindungsschicht (153) aus einem Polymermaterial gebondet wird.

9. Verfahren nach einem der Ansprüche 1 bis 7, wobei im Schritt c) das dritte Substrat (151) mit der dem zweiten Substrat (141) gegenüberliegenden Oberfläche des Stapels (120) durch direktes Oxid-zu-Oxid-Bonding verbunden wird.

10. Verfahren nach einem der Ansprüche 1 bis 9, ferner aufweisend nach Schritt b) und vor Schritt c) einen Schritt des Verjüngens der mindestens einen Halbleiterschicht (123, 125, 127) von ihrer dem zweiten Substrat (141) gegenüberliegenden Oberfläche.

11. Verfahren nach einem der Ansprüche 1 bis 10, das ferner nach Schritt b) und vor Schritt c) einen Schritt des Ausbildens von Nanostrukturen (145) in der mindestens einen Halbleiterschicht (123, 125, 127) auf ihrer dem zweiten Substrat (141) gegenüberliegenden Seite aufweist.

12. Verfahren nach einem der Ansprüche 1 bis 11, wobei das erste Substrat (121) aus Saphir hergestellt ist.

13. Verfahren nach einem der Ansprüche 1 bis 12, wobei die mindestens eine Halbleiterschicht (123, 125, 127) Galliumnitrid aufweist.

14. Verfahren nach einem der Ansprüche 1 bis 13, wobei der Stapel ein Diodenstapel (120) ist, der in der folgenden Reihenfolge von der Oberfläche des ersten Substrats (121) aus erste (123) und zweite (127) Halbleiterschichten mit entgegengesetzten Leitfähigkeitstypen aufweist

## Claims

1. A method of manufacturing electronic devices, comprising the successive steps of:
a) growing, on a surface of a first substrate (121), a stack (120) comprising at least one semiconductor layer (123, 125, 127);
b) bonding a second substrate (141) to a surface of the stack (120) opposite to the first substrate (121), and then removing the first substrate (121);
c) bonding a third substrate (151) to a surface of the stack (120) opposite to the second substrate (141), and then removing the second substrate (141);
d) cutting the assembly comprising the third substrate (151) and the stack (120) into a plurality of first chips (160), each comprising a portion of the stack (120); and
e) bonding each first chip (160), by its surface opposite to the third substrate (151), to a surface of a fourth semiconductor substrate (170) inside and on top of which a plurality of integrated control circuits (171) have been previously formed,
wherein:
I) at step b), the second substrate (141) is bonded to the surface of the stack (120) opposite to the first substrate (121) by direct bonding of a first metal layer (129) previously deposited on the surface of the stack (120) opposite to the first substrate (121) with a second metal layer (140) previously deposited on the second substrate (141), or
II) at step b), the second substrate (141) is bonded to the surface of the stack (120) opposite to the first substrate (121) by direct bonding of a first dielectric layer (201) previously deposited on the surface of the stack (120) opposite to the first substrate (121) with a second dielectric layer (203) previously deposited on the second substrate (141)..

2. The method according to claim 1, wherein each control circuit (171) comprises a plurality of metal connection pads (173) and wherein, at step e), the first chips are respectively arranged opposite the control circuits (171) so that, in each first chip, said at least one semiconductor layer (123, 125, 127) of the stack is electrically connected to the metal pads (173) of the corresponding control circuit (171).

3. The method according to claim 2, further comprising, after step e), the step of:
f) cutting the assembly comprising the fourth semiconductor substrate (170) and the first chips into a plurality of electronic devices each comprising one of said integrated control circuits (171) and the corresponding portion of the stack (120).

4. The method according to claim 3, further comprising, after step e) and before step f), a step of removal of the third substrate (151) in each first chip (160).

5. The method according to claim 3 or 4, further comprising, after step e) and before step f), a step of forming, in each of said portions of the stack (120), trenches delimiting a plurality of individually-controllable components.

6. The method according to the alternative I) of claim 1, wherein the first (129) and second (140) metal layers are made of titanium.

7. The method according to the alternative II) of claim 1, wherein the first (201) and second (203) dielectric layers are made of silicon oxide.

8. The method according to any of claims 1 to 7, wherein, at step c), the third substrate (151) is bonded to the surface of the stack (120) opposite to the second substrate (141) by means of a bonding layer (153) made of a polymer material.

9. The method according to any of claims 1 to 7, wherein, at step c), the third substrate (151) is bonded to the surface of the stack (120) opposite to the second substrate (141) by direct oxide-to-oxide bonding.

10. The method according to any of claims 1 to 9, further comprising, after step b) and before step c), a step of thinning said at least one semiconductor layer (123, 125, 127) from its surface opposite to the second substrate (141) .

11. The method according to any of claims 1 to 10, further comprising, after step b) and before step c), a step of forming of nanostructures (145) in said at least one semiconductor layer (123, 125 127) on the side of its surface opposite to the second substrate (141).

12. The method according to any of claims 1 to 11, wherein the first substrate (121) is made of sapphire.

13. The method according to any of claims 1 to 12, wherein said at least one semiconductor layer (123, 125, 127) comprises gallium nitride.

14. The method according to any of claims 1 to 13, wherein the stack is a diode stack (120) comprising, in the following order from said surface of the first substrate (121), first (123) and second (127) semiconductor layers of opposite conductivity types.
